Europäisches Patentamt

European Patent Office

Office européen des brevets

(19)

(11) EP 0 933 871 A2

(12) **EUROPEAN PATENT APPLICATION**

(43) Date of publication:
**04.08.1999 Bulletin 1999/31**

(51) Int Cl.⁶: **H03H 19/00**

(21) Application number: **99200299.8**

(22) Date of filing: **03.02.1999**

(84) Designated Contracting States:
**AT BE CH CY DE DK ES FI FR GB GR IE IT LI LU
MC NL PT SE**
Designated Extension States:
**AL LT LV MK RO SI**

(30) Priority: **03.02.1998 US 73506 P**

(71) Applicant: **TEXAS INSTRUMENTS
INCORPORATED
Dallas, TX 75265 (US)**

(72) Inventor: **Williams III, Louis A.
Plano, Texas 75025 (US)**

(74) Representative: **Holt, Michael
Texas Instruments Ltd.,
PO Box 5069
Northampton, Northamptonshire NN4 7ZE (GB)**

(54) **Linearized charge sharing circuits with nonlinear capacitors**

(57)    A switched-capacitor analog filter integrated circuit where large nonlinear MOS capacitors (C3) are sampled by smaller MOS capacitors (C2) and integrated onto linear metal-to-metal capacitors (C4) resulting in a linear input/output voltage relationship.

FIG. 1

## Description

Field of the Invention

The present invention relates to integrated circuits using high-value nonlinear capacitors to implement linear transfer functions.

Background To The Invention

There are several ways of making capacitors in an integrated circuit. One of the simplest ways is simply a "MOS" capacitor, in which a very thin high-quality dielectric (typically the same which insulates the gate of a field effect transistor from its gate) is used to provide a capacitor between the conductive gate electrode and the semiconductor substrate. This is normally done by providing a widened portion of the "poly" gate line (which is typically not all polysilicon, but may be a polysilicon/silicide combination, or may be metal clad, or may be pure metal) which completely overlays an active area of the semiconductor device. This provides a simple way to make a capacitor with a reasonably high value per unit area. However, the problem with MOS capacitors is that they are nonlinear. As the voltage applied across the capacitor increases, the enhancement or depletion of the surface of the semiconductor will change, and the capacitance therefore varies with voltage. Junction capacitors, between n+ and p+ diffusions, similarly provide a capacitance with a reasonably high value of capacitance per unit area, but with a voltage dependence, which gives nonlinearity.

In an ideal (linear) capacitor, capacitance does not vary with voltage. For linear capacitors, some type of metal-insulator-metal ("MIM") capacitor is typically used. The simplest way to do this is simply to form a capacitor between widened portions of two metal layers with the inter-level dielectric serving as the capacitor dielectric. This gives a linear capacitor, but unfortunately the capacitance per unit area is fairly low. The capacitance per unit area of a MOS capacitor can exceed the capacitance per unit area of a metal-to-metal capacitor by 20:1 or more. For example, in one 1998-era process, the MOS capacitor has a specific capacitance of about 3 femtoFarad/square micron, whereas the metal-to-metal capacitor between two of the metalization layers provides a specific capacitance of only about 0.07 femtoFarad/square micron.

One approach which is used in some analog circuits to provide more linear capacitors is to use poly-to-poly capacitors with an oxide-nitride-oxide ("ONO") dielectric. While this does provide higher specific capacitance (although still not quite as high as a MOS capacitor), it has the disadvantage that additional process steps are required. Thus it would be desirable to implement precision filters in a reasonably small area while using only the low specific capacitance of the linear metal-to-metal capacitors which are readily available.

As signal processing systems move to higher levels of integration, it becomes necessary to integrate analog functions on chips in which most of the area is consumed by digital circuitry. When the analog cirduitry occupies only a small percentage of the total chip area, economic considerations limit the addition of any processing steps not required by the digital circuits. For example, the only insulator-based capacitances typically available in a "digital" technology are the MOS gate capacitance and the parasitic capacitance between the metallization layers. Although MOS capacitors have a high capacitance per unit area, their strong voltage coefficient limits their utility in linear analog circuits. The capacitors which use parasitic metallization capacitance, hereafter called metal-metal capacitors, have good capacitance linearity but low capacitance per unit area. Neither capacitor by itself is practical for use in typical analog circuit designs.

Switched-capacitor circuit architectures can generally be viewed as charge-based designs with voltage-to-charge conversion at the input and charge-to-voltage conversion at the output. By sharing charge between MOS capacitors having common node voltages, and transferring that charge to or from metal-metal capacitors (where charge-to-voltage conversion is needed), linearity can be maintained without an inordinate sacrifice in silicon area.

Switched capacitor analog filters can require large capacitance values. In a process with no analog enhancements, the only linear capacitance available is that which exists between the metal layers. However, that capacitance has a very low density (i.e., it requires a large area for even a small capacitance). A process which could utilize high density, MOS capacitors as a substitute would provide a significant cost savings.

Summary Of The Present Invention

The present application discloses a technique for efficiently combining nonlinear (e.g. MOS) capacitors and linear (e.g. metal-to-metal) capacitors in the design of switched capacitor circuits, an essential building block in many analog systems. Charge that would normally be integrated onto a large linear capacitance is instead integrated onto a MOS capacitor. A fraction of that charge is then sampled by a smaller MOS capacitor which operates (when the signal is present) at approximately the same voltage. Because MOS capacitors have the same voltage coefficient, the charge transfer is linear.- The charge of the smaller capacitor is then integrated onto a linear capacitor for a linear charge-to-voltage conversion. Process modifications are not required for high-specific capacitance linear capacitors (such as ONO capacitors between poly levels).

An advantage is that the desired transfer function can be achieved in a solely digital process. Another advantage is that desired result is achievable with a much smaller circuit area. Another advantage of the disclosed method and structure is that it permits a less expensive process to be used for achieving a given function. Presently, more expensive analog processes are employed to fabricate the high-density linear capacitors needed to provide the function. Another advantage is that MOS capacitors, which are more easily fabricated, may be used. Another advantage is that when MOS capacitors are used, their inherent nonlinearities are compensated for in the filter circuit. Another advantage is that the MOS capacitor arrangement of the disclosed circuit allows the feedback capacitor to be very large without consuming much area. As a result, this makes it possible to achieve low cutoff frequencies at a minimal cost in area.

Brief Description of the Drawings

The present invention will now be further described, by way of example, with reference to the exemplary embodiments illustrated in the accompanying drawings wherein:

Figure 1 shows a simplified illustrative version of a single-ended charge sharing circuit.

Figure 2 shows a preferred embodiment employing differential charge sharing.

Figure 3 shows a preferred embodiment employing large MOS capacitors where "leaky" integrators are used.

Figure 4 shows a multi-stage arrangement.

Figure 5 shows a three-stage embodiment with a nonlinear middle stage.

Detailed Description of the Preferred Embodiments

The numerous innovative teachings of the present application will be described with particular reference to the presently preferred embodiment. However, it should be understood that this class of embodiments provides only a few examples of the many advantageous uses of the innovative teachings herein. In general, statements made in the specification of the present application do not necessarily delimit any of the various claimed inventions. Moreover, some statements may apply to some inventive features but not to others.

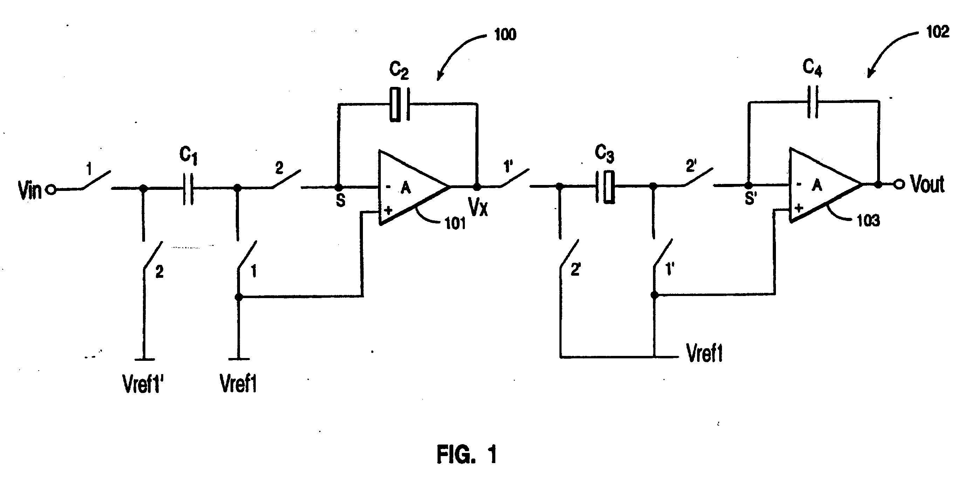

Figure 1 shows a simple illustrative preferred embodiment of a single-ended charge sharing circuit in which this linear relationship is illustrated. Shown is a series of two, two-phase switched capacitor integrators (100 and 102) in which $C_1$ and $C_4$ are linear capacitors, and $C_2$ and $C_3$ are nonlinear MOS capacitors, and amplifiers 101 and 103 are typical of those commonly used by persons skilled in the art of analog filters. The positive input of each amplifier is connected to a stable reference $V_{ref1}$, which may be, for example, ground. On the other hand, the first phase 2 switched reference $V_{ref1'}$, could be different from $V_{ref1}$, because $C_1$ is linear. Integrator 100 provides the voltage-to-charge conversion function, and integrator 102 provides the charge-to-voltage conversion function. During the first clock phase (switches designated "1" are closed), the input voltage $V_{IN}$ is sampled onto capacitor $C_1$, storing a charge of $Q_1=C_1V_{IN}$. Since capacitor $C_1$ is linear, its capacitance is independent of the input voltage $V_{IN}$. During the second clock phase, switches designated "1" are opened, and switches designated "2" are closed. The virtual ground forced at the input node S of the amplifier 101, causes the charge in capacitor $C_1$ ($C_1V_{IN}$) to be transferred to capacitor $C_2$. (The operation is similar at node S' for amplifier 103, and capacitors $C_3$ and $C_4$.) The charge $Q_2$ at capacitor $C_2$ is now equal to $Q_1$, and can be written in terms of node $V_x$ as $Q_2 = C_{2N}f(V_x) = Q_1$ (where $f(V_x)$ represents the voltage coefficient of the nonlinear capacitor $C_2$, and the constant $C_{2N}$ represents the nominal capacitance of $C_2$). During the third clock phase (switches designated "1'" are closed), the voltage $V_x$ is sampled across capacitor $C_3$, and a charge which is equal to $C_1V_{IN}$ x ($C_{3N}/C_{2N}$), is stored on capacitor $C_3$. During the fourth clock phase (switches designated "2'" are closed), the charge on capacitor $C_3$ is transferred to capacitor $C_4$, and the output voltage is

$$V_{OUT} = \frac{C_1}{C_4} \frac{C_{3N}}{C_{2N}} V_{IN}$$

There are no specific size ratios for $C_2/C_1$ and $C_4/C_3$. Capacitor $C_2$ should be much larger than $C_3$ for better filter functionality. Capacitor $C_1$ determines noise, and $C_1/C_2$ determines gain. Some typical capacitor sizes are $C_1=C_2=C_4=1$ pF, and $C_3=16$ pF. Alternatively, values may be such that $C_1=C_2=C_4=5$ pF, and $C_3=80$ pF (these values are for a design with a higher noise specification). In a digital process, specific capacitance (such as metal-metal) ratios approximate 20:1, for example, in one 1998 process, MIM approximates 0.07 femtoFarad/micro-meter[2]; whereas in a MOS process, capacitance ratios approximate 3 femtoFarad/micro-meter[2]. This is not as necessary if ONO capacitors are used.

No specific capacitor ratios must exist for linearity compensation, but only for increased noise immunity. Thus, the output voltage is a linear function of the input voltage. This technique is extremely useful when capacitor $C_2$ must be relatively large, and no high-density linear capacitor is available. In that case, MOS capacitors can be used where high capacitance is needed, and the charge can eventually be linearized by integrating from a similar MOS capacitor onto a linear capacitance. (Note: this assumes that capacitors $C_2$ and $C_4$ were initially discharged. However, the linearity holds even when there is charge stored on these capacitors initially.)

The above circuit discussion comprises a simple step-by-step operation using four clock phases. However, in reality, the clocking may require only two phases such that the input is being sampled onto $C_1$ while the output of integrator 100 is being sampled onto

$C_3$.

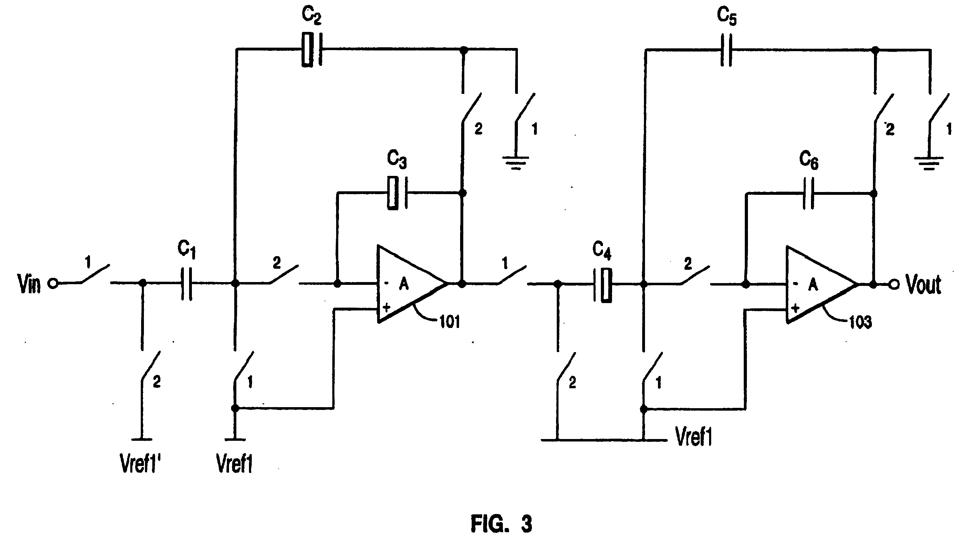

One example where a large capacitance is needed is the leaky integrator shown in Figure 3. The introduction of capacitor $C_2$ (leaky capacitor) limits DC gain to a finite value (low-pass filter function) where the low-pass cutoff for the first integrator is determined by the ratio of capacitors $C_3$ to $C_2$. The MOS capacitor arrangement allows capacitor $C_3$ to be very large without consuming much area. Thus low cutoff frequencies are realized at a minimal cost in area.

Instead of the four clock cycles used in Figure 1, a two-phase non-overlapping clock can be used. The switches marked "1" are closed during the first phase, and the switches marked "2" are closed during the second phase. During the first phase, the input is sampled onto capacitor $C_1$. During the second clock phase, the charge on $C_1$ is integrated onto capacitor $C_3$. Capacitor $C_2$ bleeds off a controlled fraction of the charge from $C_3$ for each sample, and thus creates a "leaky" integrator (for DC stability). The positive input of each amplifier is connected to a stable reference $V_{ref1}$, which may be, for example, ground. On the other hand, the first phase 2 switched reference $V_{ref1'}$, could be different from $V_{ref1}$, because $C_1$ is linear. Some typical capacitor sizes are $C_1=C_2=C_4=C_5=C_6=1$ pF, and $C_3=16$ pF. Alternatively, values may be such that $C_1=C_2=C_4=C_5=C_6=5$ pF, and $C_3=80$ pF (these values are for another design with a higher noise specification). Either all of the capacitor top plates should be connected together, or alternatively, all of the bottom plates, but only during selected clock phases.

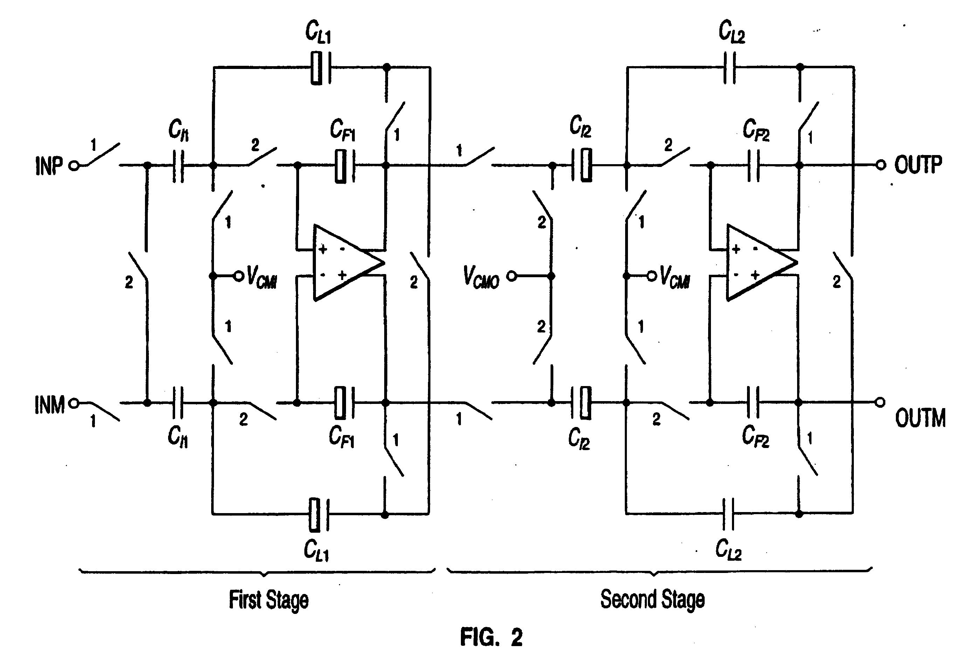

Figure 2 shows a preferred embodiment employing differential charge sharing. The single-ended charge sharing technique from the previous section can be extended to a two-stage fully-differential switched capacitor filter that uses MOS to metal-metal charge sharing. Capacitors $C_{I1}$, $C_{L2}$, and $C_{F2}$ are linear metal-metal capacitors constructed for example, using a three-layer sandwich of, the second, third, and fourth layers of metal. Capacitors $C_{L1}$, $C_{F1}$ (a large integration capacitor), and $C_{I2}$ are high-density PMOS capacitors operated in the accumulation region. Most of the out-of-band noise attenuation occurs in the first stage. The purpose of the second stage is to perform the MOS to metal-metal charge transfer. A two-phase, non-overlapping clock is used; the switches marked "1" are closed during the first clock phase, and the switches marked "2" are closed during the second clock phase. The common-mode input voltage $V_{CMI}$ of each of the first and second stages must be equal. During the first clock phase, the differential inputs for each stage $V_{CMI}$ are sampled across integrating capacitors $C_{I1}$ and $C_{I2}$, and the leak capacitors $C_{L1}$ and $C_{L2}$ are discharged. During the second clock phase, the charge on integrating capacitors $C_{I1}$ and $C_{I2}$ is integrated onto capacitors $C_{F1}$ and $C_{F2}$, respectively. Also during the second clock phase, the leak capacitors $C_{L1}$ and $C_{L2}$ bleed off a controlled fraction of the charge on the integrating capacitors, creating leaky integrators with finite DC gain. The transfer functions for these filter stages, $H_1(z)$ and $H_2(z)$, are $H_n(z) = A_n (1-g_n)/(1-g_n z^{-1})$, where $A_n = C_{In}/C_{Ln}$, and $g_n = 1 - C_{Ln}/C_{Fn}$, and n is 1 or 2. Assuming that the amplifiers are perfect and that there is no capacitor mismatch, the MOS capacitors will all have the same node voltages. Thus the linear charge sharing principle described in the previous section will still hold.

Note that having a different common-mode input and output voltage for the amplifiers does not violate the equal node voltage principle. The only requirement is that the common-mode input voltage for both amplifiers be the same, and that the common-mode output voltage of the first amplifier equal $V_{CMO}$. The benefit of the charge sharing is that where a large capacitor ratio is needed, a MOS capacitor can be used. In the example above, achieving a low cutoff frequency requires that $g_1$ be very close to unity (i.e. $C_{F1}$ is much greater than $C_{L1}$). However, input referred kT/C noise requirements limit how small $C_{L1}$ can be. Thus, for a low cutoff frequency and low noise, $C_{F1}$ must be large (e.g. in an audio DAC with 90 dB Linearity, capacitor $C_{F1}$ was sixteen times larger than $C_{L1}$). Because $C_{F1}$ is a MOS capacitor, making $C_{F1}$ large does not cause a large area penalty.

The Applicant discusses additional applications of the MOS to metal-metal charge transfer technique in Applicant's copending U:S. Patent application 60/073,584, Hybrid FIR/IIR Analog Filter, which is herein incorporated by reference.

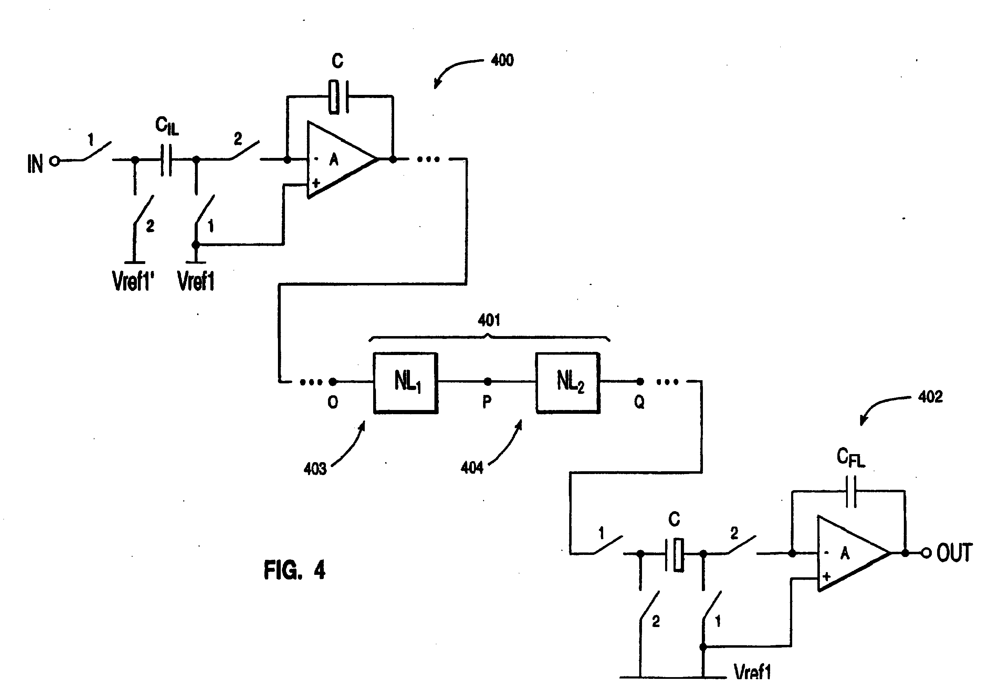

Figure 4 shows a multi-stage arrangement. The simplified two-stage charge-sharing circuit of Figure 1 may be extended to n-stages. An initial stage 400 comprises an amplifier and a linear component $C_{IL}$, and a final stage 402 comprises an amplifier and a final linear component $C_{FL}$. At least one pair 401 of a plurality of intermediate stages may comprise nonlinear stages 403 and 404 connected at a common node P. Implementation of components (linear or nonlinear) may be generalized as node-by-node. For example, components common to node P should both comprise either the same linear characteristics, or the same nonlinear characteristics. If two nonlinear capacitors meet at a node, they should have approximately the same signal voltage (regardless of the input signal level). In this case, the ratio of the charge stored on the two capacitors would be just the ratio of their sizes, and would be independent of the nonlinearity. Therefore, voltage at the output OUT is linear relative to the voltage at the input IN. The positive input of each amplifier is connected to a stable reference $V_{ref1}$, which may be, for example, ground. On the other hand, the first phase 2 switched reference $V_{ref1'}$, could be different from $V_{ref1}$, because $C_1$ is linear.

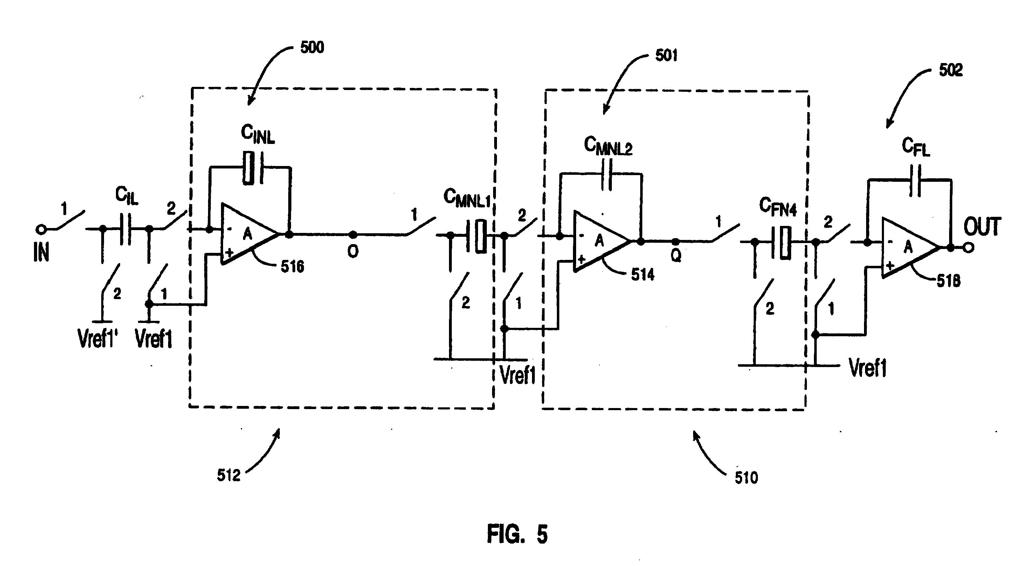

Figure 5 shows a three-stage embodiment with a middle stage containing nonlinear capacitors. Initial stage 500 comprises a linear input capacitor $C_{IL}$, an amplifier 516, and a nonlinear feedback capacitor $C_{INL}$. The final stage 502 comprises a nonlinear input capacitor $C_{FNL}$, an amplifier 518, and a linear feedback capacitor

$C_{FL}$. The middle stage 501 comprises a nonlinear input capacitor $C_{MNL1}$, an amplifier 514, and a nonlinear feedback capacitor $C_{MNL2}$. The technique is to provide components with matching nonlinearity characteristics at common nodes, and with the same (or nearly the same) voltage across these common nodal components. Thus, feedback capacitor $C_{INL}$, and input capacitor $C_{MNL1}$ of the middle stage 501 (which have a common node O) should have matching nonlinearity characteristics. Similarly, feedback capacitor $C_{MNL2}$ of the middle stage 501, and input capacitor $C_{FNL}$ of the final stage 502 (which have a common node Q) should also have matched nonlinearity characteristics. Therefore, voltage at the output OUT is linear relative to the voltage at the input IN.

In Figure 5, two subcircuits 510 and 512 have been drawn to indicate how the non-linear capacitors are to be matched. (Note that these subcircuits do not exactly correspond to the stages as those would usually be described by engineers.) Subcircuit 510 includes the gain element 514 of the second stage 501, its nonlinear feedback capacitor $C_{MNL2}$, and also includes the following input capacitor $C_{FNL}$ of the following stage 502. Similarly, subcircuit 512 includes the gain element 516 of the first stage 500, it's feedback capacitor $C_{INL}$, and the following input capacitor $C_{MNL1}$. The positive input of each gain element is connected to a stable reference $V_{ref1}$, which may be, for example, ground. On the other hand, the first phase 2 switched reference $V_{ref1'}$, could be different from $V_{ref1}$, because $C_1$ is linear.

The MOS to metal-metal charge transfer technique requires that all non-linear capacitors which share a common node, share approximately the same voltages (close enough to ignore nonlinearity), when voltages are sampled at their unshared nodes. The nodal voltages at other times are not relevant to the nonlinearity matching. For example, if MOS capacitors $C_X$ and $C_Y$ have the same voltage applied to them, and are constructed of identical materials, the ratio of the charge on $C_X$ to that on $C_Y$ will simply be the ratio of the areas of the two capacitors. Consider a charge $Q_X$ that is sampled onto a MOS capacitor $C_X$. The voltage on that capacitor is governed by the equation $Q_X=C_X f(V_1)$; where $f(V_1)$ is the nonlinear voltage-to-charge relationship for the MOS capacitor $C_X$. (For an ideal capacitor, $Q=CV$, i. e. $f(V) = V$.) Now consider a second capacitor $C_Y$ that is forced to have the same voltage as $C_X$. Its charge is $Q_Y=C_Y f(V_1)$. Therefore, the linear relationship of $Q_X/Q_Y=C_X/C_Y$ is free of the capacitor nonlinearity factor $f(V_1)$.

Thus, in a N-stage implementation, the nonlinear capacitances are not necessarily matched up exactly in pairs - instead they are matched node-by-node (nonlinear capacitors on either side of a node having approximately the same characteristics), possibly ignoring the presence of a unity gain stage. Even more generally, it can be stated that the nonlinear elements are matched within linear domains, where a node is a linear domain, and the presence of a switch or a gain element of approximately Unity gain can be ignored.

The important technique is that in conjunction with a nonlinear capacitor and the voltage $V_X$ across it, another nonlinear capacitor of the same material is used, and the same voltage (with the same polarity) is placed across it. Then the ratio of charge on the two capacitors would just be the ratio of their sizes, and would be independent of the nonlinearity.

According to a disclosed class of innovative embodiments, there is provided: A switched-capacitor integrated circuit analog filter, comprising: a linear input capacitor connected to receive an input signal; one or more switched capacitor subcircuits operatively connected together to process the voltage on said input capacitor with a desired transfer function; wherein at least one of said subcircuits includes a gain element having an output and an input, a nonlinear feedback capacitor operatively connected between said input and said output, and a nonlinear following switched capacitor which is operatively connected to sample said output; and wherein said one subcircuit is operated so that said feedback and following capacitors, when active, are operated at approximately equal voltages; whereby nonlinearities of said nonlinear feedback and following capacitor are compensated.

According to another disclosed class of innovative embodiments, there is provided: A switched capacitor integrated circuit analog filter, comprising: a first switched capacitor stage is connected to receive an input voltage, and having a first input capacitor and a first feedback capacitor connected together with a first gain element; and a final switched capacitor stage connected in series and following said first stage, and connected to present an output voltage, and having a second input capacitor and a second feedback capacitor connected with a second gain element; and wherein said first input capacitor and said second feedback capacitor are both substantially linear; and wherein said second input capacitor and said first feedback capacitor are both nonlinear, and have the same type of nonlinearity characteristics; wherein said first and final stages are configured to provide a desired transfer function; whereby nonlinearities in said capacitors are compensated, and said output voltage is a linear function of said input voltage.

According to another disclosed class of innovative embodiments, there is provided: a method of switched capacitor filtering, comprising the steps of: (a.) sampling and storing an input voltage in a first substantially linear capacitor; (b.) converting said input voltage into charge stored on a nonlinear second capacitor, and then switching a nonlinear third capacitor to receive a portion of said charge from said second capacitor; and after said step (b.), performing zero or more further repetitions of said step (b.), using further respective ones of said second and third capacitors for each said further repetition, and then (c.) converting charge from one of said third capacitors into an output voltage, using a linear output circuit; whereby said output voltage is a linear function of said input voltage.

As will be recognized by those skilled in the art, the innovative concepts described in the present application can be modified and varied over a tremendous range of applications, and accordingly the scope of patented subject matter is not limited by any of the specific exemplary teachings given, but is only defined by the issued claims.

For example, within the constraints well-known to those of ordinary skill, while four clock phases were used for illustrative purposes in the embodiment of Figure 1, two non-overlapping clock phases could be used.

For another example, within the constraints well-known to those of ordinary skill, other types of linear or nonlinear capacitors can be used.

For another example, within the constraints well-known to those of ordinary skill, internal stages can be linear.

For another example, within the constraints well-known to those of ordinary skill, any number of internal stages may be used as long as the paired stages provide inverse linearity.

For another example, within the constraints well-known to those of ordinary skill, the differential embodiment is not limited to semi-digital inputs, but can also receive the output of any switched capacitor filter.

For another example, within the constraints well-known to those of ordinary skill and subject to the rules described above, the disclosed inventions can be applied to any switched capacitor circuit with any number of charge-sharing stages.

For another example, within the constraints well-known to those of ordinary skill, junction capacitors may be used to provide a nonlinear capacitor.

For another example, within the constraints well-known to those of ordinary skill, other capacitor processes may be used, for example, poly over an n-well with an n+ contact.

For another example, as will be obvious to those of ordinary skill in the art, other circuit elements can be added to, or substituted into, the specific circuit topologies shown.

For another example, within the constraints well-known to those of ordinary skill, the structure can also be embedded into hybrid process flows, such as BiCMOS or smart-power processes.

For another example, DC gain can optionally be limited by other stages, so that it is not strictly necessary to rely on capacitor C2 for this.

**Claims**

1. A switched-capacitor integrated circuit analog filter, comprising:

a linear input capacitor connected for receiving an input signal;
one or more switched capacitor subcircuits operatively connected together for processing the voltage on said input capacitor with a desired transfer function;

wherein at least one of said subcircuits includes

a gain element having an output and an input, a nonlinear feedback capacitor operatively connected between said input and said output, and a switched nonlinear following capacitor which is operatively connected to sample said output; and wherein said one subcircuit is operated so that said feedback and following capacitors, when active, are operated at approximately equal voltages;

whereby nonlinearities of said nonlinear feedback and following capacitor are compensated.

2. The integrated circuit of Claim 1, wherein said input capacitor is a switched series-connected capacitor.

3. The integrated circuit of Claim 1 or Claim 2, wherein the ratio of said feedback capacitor to said input capacitor is approximately equal to the ratio of said second subcircuit input capacitor to a second subcircuit feedback capacitor.

4. The integrated circuit of any of Claims 1 to 3, wherein said input capacitor and a second subcircuit feedback capacitor are linear metal-to-metal capacitors.

5. The integrated circuit of any of Claims 1 to 4, wherein said following capacitor and said feedback capacitor are MOS capacitors.

6. The integrated circuit of any of Claims 1 to 5, wherein said feedback capacitor is substantially larger in area than said input capacitor.

7. The integrated circuit of any of Claims 1 to 6, wherein said feedback capacitor and said following capacitor operate at the same node voltages when carrying a signal being filtered.

8. The integrated circuit of any of Claims 1 to 7, wherein a switched leakage capacitor is connected in parallel with said feedback capacitor.

9. The integrated circuit of any of Claims 1 to 8, wherein each said gain element is fully differential, and wherein each said capacitor is replicated on both sides of a fully differential signal path.

10. A switched capacitor integrated circuit analog filter, comprising:

a first switched capacitor stage connected to receive an input voltage, and having a first input capacitor and a first feedback capacitor connected together with a first gain element; and

a final switched capacitor stage operatively connected in series with and following said first stage, and connected to present an output voltage, and having a second input capacitor and a second feedback capacitor connected with a second gain element;

wherein said first input capacitor and said second feedback capacitor are both substantially linear;

wherein said second input capacitor and said first feedback capacitor are both nonlinear, and have the same type of nonlinearity characteristics;

and wherein said first and final stages are configured to provide a desired transfer function;

whereby nonlinearities in said capacitors are compensated, and said output voltage is a linear function of said input voltage.

**FIG. 1**

EP 0 933 871 A2

FIG. 2

FIG. 3

IN

$C_{iL}$

Vref1'   Vref1

$C$

A

400

$NL_1$   $NL_2$

O   P   Q

401

403   404

$C$

Vref1

$C_{FL}$

A

OUT

402

**FIG. 4**

FIG. 5